# EUROPÄISCHE PATENTSCHRIFT

(11) **EP 0 626 729 B1**
(45) Veröffentlichungstag und Bekanntmachung des Hinweises auf die Patenterteilung: **24.04.1996**
(21) Anmeldenummer: 94107224.1
(22) Anmeldetag: 09.05.1994
(51) Int. Cl.: H01L 29/735, H01L 21/331

(54) **Herstellungsverfahren für lateralen Bipolartransistor**
Method for producing a lateral bipolar transistor
Procédé de fabrication pour un transistor bipolaire latéral

(30) Priorität: 27.05.1993 DE 4317720
(43) Veröffentlichungstag der Anmeldung: 30.11.1994
(73) Patentinhaber: SIEMENS AKTIENGESELLSCHAFT, D-80333 München (DE)
(72) Erfinder: Klose, Helmut, Dr., D-81929 München (DE)

(56) Entgegenhaltungen:
- EP-A- 0 137 992
- IBM TECHNICAL DISCLOSURE BULLETIN, Bd.32, Nr.3B, August 1989 Seiten 59 - 60, XP29924
- IBM TECHNICAL DISCLOSURE BULLETIN, Bd.32, Nr.6B, November 1989 Seiten 157 - 159, XP73696

## Beschreibung

Die vorliegende Erfindung betrifft ein Herstellungsverfahren für einen lateralen Bipolartransistor auf Silizium.

Ein lateraler Bipolartransistor gemäß dem Oberbegriff des Hauptanspruchs ist bereits aus der Veröffentlichung "Japanese Journal of Applied Physics, Vol. 30, No. 12B, Dec. 1991, pp. L2080 - L2082" bekannt.

Bei lateral angeordneten Bipolartransistoren stellt sich häufig die Aufgabe, die parasitären Kapazitäten gering zu halten und eine hohe Integrationsdichte mit einem einfachen Herstellungsverfahren zu erreichen.

In der EP 0 137 992 A3 ist ein lateraler Bipolartransistor auf SOI-Substrat beschrieben. Emitter-, Basis- und Kollektorbereiche umfassen die gesamte Dicke der Siliziumschicht. Auf dem Basisbereich ist eine hoch dotierte Basiselektrode aufgebracht. In dem Artikel in IBM Technical Disclosure Bulletin, Vol. 32, no. 3B, Seiten 59 bis 60 (1989) ist eine Transistorstruktur beschrieben, bei der auf einem SOI-Substrat ein vertikaler npn-Transistor mit einem lateralen pnp-Transistor kombiniert ist. Der elektrische Anschluß der verschiedenen Bereiche erfolgt über auf der Oberseite zusätzlich aufgebrachte Schichten.

Aufgabe der vorliegenden Erfindung ist es, ein Herstellungsverfahren für einen Bipolartransistor anzugeben, mit dem der Transistor außerdem in möglichst wenigen Schritten herstellbar ist.

Diese Aufgabe wird mit dem Herstellungsverfahren gemäß den Merkmalen des Anspruches 1 gelöst. Weitere Ausgestaltungen ergeben sich aus den abhängigen Ansprüchen.

Bei dem erfindungsgemäßen Verfahren wird von einem Substrat ausgegangen, bei dem eine dünne Siliziumschicht auf einer Isolationsschicht angeordnet ist. Dieses Substrat kann z. B. ein SOI-Substrat sein, wie es z. B. mittels SIMOX oder Waferbonding hergestellt werden kann. Die Siliziumschicht sollte dabei eine Dicke von etwa 100 nm aufweisen. Diese Siliziumschicht wird mit einer Grunddotierung von etwa 10¹⁷ bis 10¹⁸ cm⁻³ versehen. Unter Verwendung dieses Ausgangsmateriales wird eine Struktur hergestellt, bei der eine aus dieser ursprünglichen Siliziumschicht hergestellte Basisschicht lateral an eine Emitterschicht bzw. eine Kollektorschicht angrenzt und diese Emitter- und Kollektorschichten mit Ausnahme eines kurzen, die Basisschicht kontaktierenden Abschnittes auf einer Dielektrikumschicht angeordnet sind.

Es folgt eine Beschreibung des erfindungsgemäßen Herstellungsverfahrens und des so hergestellten Transistors anhand der Figuren 1 bis 7.
- Fig. 1: zeigt den durch das erfindungsgemäße Verfahren hergestellten Transistor im Querschnitt.
- Fig. 2: zeigt den in Fig. 1 bezeichneten Schnitt in Draufsicht.
- Fig. 3 bis 7: zeigen verschiedene Schritte des erfindungsgemäßen Herstellungsverfahrens

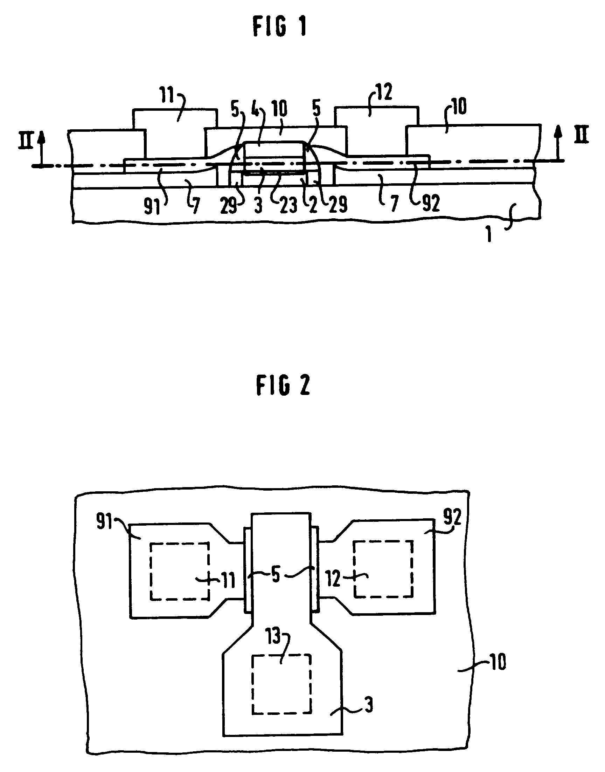

Bei der Struktur des Transistors entsprechend Fig. 1 befindet sich auf der Isolationsschicht 1 des Substrates eine im Bereich des eigentlichen Transistors streifenförmige dotierte Basisschicht 2. Auf dieser Basisschicht 2 befindet sich eine hoch dotierte Basiskontaktschicht 3, die in Verlängerung des streifenförmigen Anteiles sich zu einer größeren Anschlußfläche ausweitet. Diese Basiskontaktschicht 3 ist auf der Oberseite und lateral durch eine Dielektrikumschicht 4 und durch innere Spacer 5 elektrisch isoliert. An die Basisschicht 2 beidseitig angrenzend befinden sich die Emitterschicht 91 und die Kollektorschicht 92, die mit dem Leitungstyp dotiert sind, welcher dem der Basisschicht entgegengesetzt ist. Diese Schichten sind aus Silizium, wobei die Basisschicht 2 aus einer ursprünglich ganzflächig vorhandenen Monosiliziumschicht hergestellt ist, während die übrigen Schichten nachträglich aufgebrachtes Polysilizium sind. In Fig. 1 ist ein Übergangsbereich 23 der Basisschicht 2 eingezeichnet, der durch aus der Basiskontaktschicht 3 in die Basisschicht 2 diffundierte Akzeptoren bzw. Donatoren entstanden ist. Entsprechend befinden sich in der Basisschicht 2 in den an die Emitterschicht 91 und die Kollektorschicht 92 angrenzenden Bereichen Übergangsbereiche 29, die entsprechend durch Ausdiffusion von Ladungsträgern aus der Emitterschicht 91 in die Basisschicht 2 bzw. aus der Kollektorschicht 92 in die Basisschicht 2 entstanden sind. Die wesentlichen Anteile der Emitterschicht 91 und der Kollektorschicht 92 befinden sich auf jeweils einer Dielektrikumschicht 7, die in der Schichtebene der Basisschicht 2 angeordnet ist und zu dieser Basisschicht 2 jeweils in einem geringen Abstand angeordnet ist, so daß die Emitterschicht 91 und die Kollektorschicht 92 zwischen der Basisschicht 2 und dieser strukturierten Dielektrikumschicht 7 jeweils die Basisschicht 2 kontaktieren. Diese Struktur ist auf der Oberseite mit einer Planarisierungsschicht 10 aus einem Dielektrikum bedeckt, und es sind in Kontaktlöchern dieser Planarisierungsschicht 10 ein Emitterkontakt 11, ein Kollektorkontakt 12 und ein Basiskontakt aufgebracht.

Fig. 2 zeigt den in Fig. 1 bezeichneten Schnitt, wobei die Kontaktflächen zwischen der Emitterschicht 91 und dem Emitterkontakt 11, zwischen der Kollektorschicht 92 und dem Kollektorkontakt 12 und zwischen der Basiskontaktschicht 3 und dem Basiskontakt 13 jeweils mit gestrichelten Linien eingezeichnet sind. Es ist erkennbar, daß die Emitterschicht 91 und die Kollektorschicht 92 jeweils bis an den streifenförmigen Anteil der Basisschicht 2 bzw. der darauf befindlichen Basiskontaktschicht 3 herangeführt sind und sich nach außen hin jeweils zu Anschlußflächen aufweiten. Die elektrische Isolierung zwischen der Basiskontaktschicht 3 und der Emitterschicht 91 bzw. der Kollektorschicht 92 erfolgt durch die eingezeichneten Spacer 5.

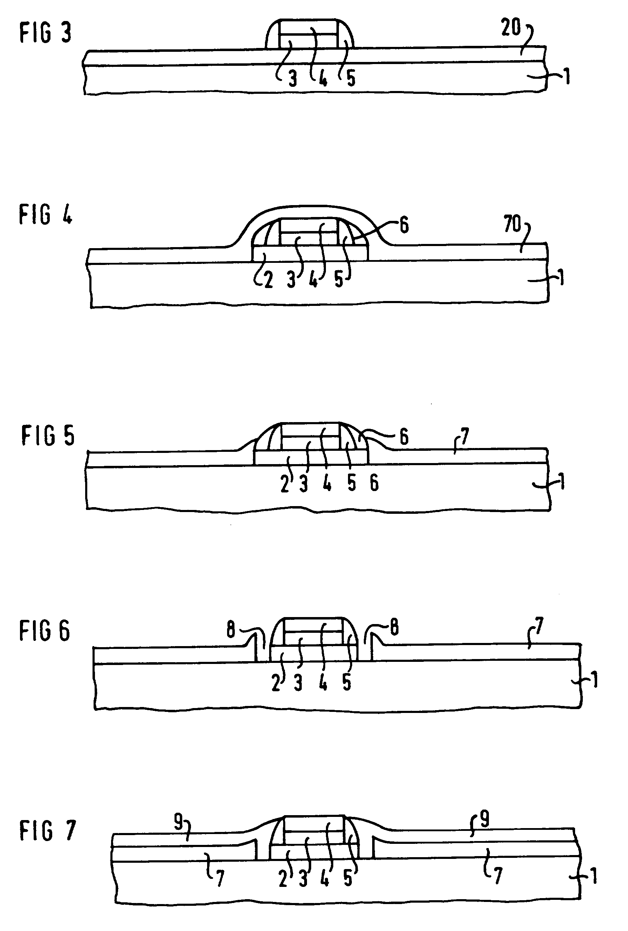

Die Herstellung dieses Transistors erfolgt in der Weise, daß auf die mit der Grunddotierung versehene Siliziumschicht 20 (s. Fig. 3), die sich auf der Isolationsschicht 1 des Substrates befindet, eine Polysiliziumschicht und darauf eine Dielektrikumschicht z. B. mittels CVD abgeschieden werden. Die Polysiliziumschicht wird für die Basis hoch dotiert, was z. B. durch eine Implantation während des Aufbringens oder anschließend erfolgen kann. Die Dielektrikumschicht kann z. B. unter Verwendung von Tetraethylorthosilan aufgebrachtes SiO₂ sein. Diese Doppelschicht wird dann z. B. mittels Trockenätzverfahren strukturiert. Von der Polysiliziumschicht verbleibt die im Bereich des eigentlichen Transistors streifenförmig strukturierte Basiskontaktschicht 3 mit der darauf befindlichen Dielektrikumschicht 4 als Isolation. Es wird anschließend eine konforme Dielektrikumschicht (z. B. CVD-SiO₂) abgeschieden und anisotrop zurückgeätzt, um seitliche Spacer 5 im Bereich dieser streifenförmigen Anteile der Basiskontaktschicht 3 und der darauf befindlichen Dielektrikumschicht 4 herzustellen. Dieser Vorgang wird mit einer weiteren Schicht, deren Material selektiv bezüglich des Materials der inneren Spacer 5 ätzbar ist, wiederholt. Auf diese Weise werden äußere Spacer 6 auf den der Basiskontaktschicht 3 gegenüberliegenden Seiten der inneren Spacer 5 hergestellt. Bei Verwendung von SiO₂ für die inneren Spacer 5 können diese äußeren Spacer 6 z. B. aus Si₃N₄ hergestellt werden. Die inneren Spacer 5 und äußeren Spacer 6 werden zusammen mit der Dielektrikumschicht 4 als Maske benutzt, um von der Siliziumschicht 20 alles bis auf einen für die Basisschicht 2 vorgesehenen Anteil zu entfernen. Auf die sich aus diesem Verfahrensschritt (z. B. Trockenätzung) ergebende Struktur, die in Fig. 4 gezeichnet ist, wird ganzflächig konform eine weitere Dielektrikumschicht 70 aus einem Material, bzgl. dessen die äußeren Spacer 6 selektiv ätzbar sind, (z. B. SiO₂) aufgebracht. Diese weitere Dielektrikumschicht 70 wid wie in Fig. 5 dargestellt planarisierend z. B. mittels CMP (Chemical mechanical polishing) oder unter Verwendung von Fotolack zurückgeätzt. Die verbleibenden Anteile 7 dieser weiteren Dielektrikumschicht befinden sich nur noch seitlich der äußeren Spacer 6 und geben diese an der Oberfläche frei. Die äußeren Spacer 6 können daher (vorzugsweise isotrop) entfernt werden. Da die weitere Dielektrikumschicht aus einem Material aufgebracht wurde, bezüglich dessen diese äußeren Spacer 6 selektiv ätzbar sind, werden die verbliebenen Anteile 7 dieser weiteren Dielektrikumschicht bei diesem Ätzprozeß nicht entfernt. Die sich durch das Entfernen der äußeren Spacer 6 ergebenden Öffnungen werden genutzt, um die Basisschicht 2 im Bereich dieser Öffnungen rückzuätzen. Zwischen der Basisschicht 2 und der strukturierten Dielektrikumschicht 7 befinden sich jetzt Öffnungen 8 (s. Fig. 6), in denen die Oberfläche der Isolationsschicht 1 freigelegt ist.

Es erfolgt eine konforme Abscheidung einer Schicht 9 von Polysilizium oder einem anderen Kontaktmaterial für die Herstellung der Emitterschicht und der Kollektorschicht (z. B. Siliziumkarbid). Diese Schicht 9 wird für den Emitter und Kollektor hoch dotiert, was entweder beim Aufbringen oder anschließend durch Implantation erfolgen kann. Diese Schicht 9 (s. Fig. 7) wird wiederum planarisierend zurückgeätzt (z. B. CMP oder Planarisierung mittels Fotolack). Die Anteile dieser Schicht 9, die nach diesem Ätzprozeß verbleiben, werden mittels Lackmaske strukturiert, so daß sich die Struktur, die in Fig. 2 in Draufsicht dargestellt ist, ergibt. Die Schicht 9 zerfällt in die Emitterschicht 91 und die Kollektorschicht 92 mit den entsprechend aufgeweiteten Anschlußbereichen. Es wird eine Planarisierungsschicht 10 aus einem Dielektrikum aufgebracht, in der die Kontaktlöcher für den elektrischen Anschluß hergestellt werden, und anschließend die Kontakte aus Metall für Emitter, Kollektor und Basis aufgebracht.

Der durch das erfindungsgemäße verfahren hergestellte Transistor läßt sich daher über vier Fototechnikschritte herstellen und realisiert daher einen hochintegrierten Bipolartransistor, dessen gesamtes aktives Gebiet nur etwa das 1,8-fache der sich aus der minimalen Strukturfeinheit ergebenden Fläche beträgt.

## Patentansprüche

1. Herstellungsverfahren für einen lateralen Bipolartransistor, bei dem
in einem ersten Schritt auf einer Siliziumschicht (20), die sich auf einer Isolationsschicht (1) befindet und mit einer für eine Basisschicht (2) vorgesehenen Dotierung versehen ist, eine hoch dotierte Polysiliziumschicht (3) für einen Basisanschluß und darauf eine Dielektrikumschicht (4) aufgebracht und zu einem streifenförmigen Anteil strukturiert werden,
in einem zweiten Schritt lateral zu dem für eine Basis vorgesehenen streifenförmigen Anteil dieser strukturierten Schichten (3, 4) innere Spacer (5) aus einem Dielektrikum hergestellt werden,
in einem dritten Schritt aus einem Dielektrikum, das bezüglich des Dielektrikums dieser inneren Spacer (5) selektiv ätzbar ist, lateral zu diesen Spacern (5) äußere Spacer (6) hergestellt werden,
in einem vierten Schritt unter Verwendung der inneren Spacer (5), der äußeren Spacer (6) und der strukturierten Dielektrikumschicht (4) als Maske die auf der Isolationsschicht (1) befindliche Siliziumschicht (20) außerhalb des von dieser Maske abgedeckten Bereiches vollständig entfernt wird, so daß eine Siliziumschicht (2) verbleibt,
in einem fünften Schritt ganzflächig konform eine weitere Dielektrikumschicht (70) aufgebracht wird,
in einem sechsten Schritt diese weitere Dielektrikumschicht (70) planarisierend bis auf seitlich der äußeren Spacer (6) verbleibende Anteile (7) rückgeätzt wird,
in einem siebenten Schritt die äußeren Spacer (6) selektiv entfernt werden,
in einem achten Schritt unter Verwendung der aufgebrachten dielektrischen Schichten (4, 5) als Maske der verbliebene Anteil der Siliziumschicht (2) im Bereich der entfernten äußeren Spacer (6) bis auf die Isolationsschicht (1) entfernt wird, so daß beidseitig Öffnungen (8) entstehen,
in einem neunten Schritt ganzflächig eine für Emitter und Kollektor vorgesehene hoch dotierte Schicht (9) aufgebracht wird,
in einem zehnten Schritt diese Schicht (9) planarisierend rückgeätzt und strukturiert wird, so daß eine Emitterschicht (91) und eine Kollektorschicht (92) voneinander getrennt entstehen, und
in einem elften Schritt eine Planarisierungsschicht (10) aus einem Dielektrikum aufgebracht wird, in der anschließend Kontakt löcher für elektrischen Anschluß gebildet werden, und anschließend ein Emitterkontakt (11), ein Kollektorkontakt (12) und ein Basiskontakt (13) aufgebracht werden.

2. Verfahren nach Anspruch 1, bei dem
in dem ersten Schritt für die Dielektrikumschicht (4), in dem zweiten Schritt für die inneren Spacer (5) und in dem fünften Schritt für die weitere Dielektrikumschicht (70) SiO₂ verwendet wird und
in dem dritten Schritt für die äußeren Spacer (6) Si₃N₄ verwendet wird.

3. Verfahren nach Anspruch oder 2, bei dem
in dem ersten Schritt die Polysiliziumschicht (3) p⁺-leitend dotiert hergestellt wird und
in dem neunten Schritt die Schicht (9) n⁺-leitend dotiert aus einem siliziumhaltigen Material hergestellt wird.

## Claims

1. Method for producing a lateral bipolar transistor, in which
in a first step there is applied to a silicon layer (20), which is situated on an insulation layer (1) and is provided with a doping intended for a base layer (2), a highly doped polysilicon layer (3) for a base connection, a dielectric layer (4) is applied to the said polysilicon layer and the two layers are structured to form a strip-shaped portion,
in a second step inner spacers (5) made of a dielectric are produced laterally with respect to the strip-shaped portion, which is intended for a base, of these structured layers (3, 4),
in a third step outer spacers (6) are produced laterally with respect to these spacers (5) from a dielectric which can be selectively etched with respect to the dielectric of these inner spacers (5),
in a fourth step, using the inner spacers (5), the outer spacers (6) and the structured dielectric layer (4) as a mask, the silicon layer (20) which is situated on the insulation layer (1) is completely removed outside the region covered by this mask, with the result that a silicon layer (2) remains,
in a fifth step a further dielectric layer (70) is applied conformally over the whole area,
in a sixth step this further dielectric layer (70) is etched back in a planarizing manner except for portions (7) remaining to the side of the outer spacers (6),
in a seventh step the outer spacers (6) are selectively removed,
in an eighth step, using the applied dielectric layers (4, 5) as a mask, the remaining portion of the silicon layer (2) in the region of the removed outer spacers (6) is removed down to the insulation layer (1), producing openings (8) on both sides,
in a ninth step a highly doped layer (9) intended for the emitter and collector is applied over the whole area,
in a tenth step this layer (9) is etched back in a planarizing manner and is structured, with the result that an emitter layer (91) and a collector layer (92) are produced in a manner separate from one another, and
in an eleventh step a planarization layer (10) made of a dielectric is applied, in which layer contact holes for electrical connection are subsequently formed, and an emitter contact (11), a collector contact (12) and a base contact (13) are subsequently applied.

2. Method according to Claim 1, in which SiO₂ is used in the first step for the dielectric layer (4), in the second step for the inner spacers (5) and in the fifth step for the further dielectric layer (70), and Si₃N₄ is used in the third step for the outer spacers (6).

3. Method according to Claim 1 or 2, in which in the first step the polysilicon layer (3) is produced with p⁺-conducting doping, and
in the ninth step the layer (9) is produced, with n⁺-conducting doping, from a silicon-containing material.

## Revendications

1. Procédé de fabrication d'un transistor bipolaire latéral dans lequel,
lors d'une première étape, sur une couche de silicium (20) qui se trouve sur une couche isolante (1) et est munie d'un dopage prévu pour une couche de base (2), une couche de polysilicium (3) fortement dopée est appliquée pour réaliser une jonction de base et une couche de diélectrique (4) est appliquée sur cette dernière couche, lesquelles sont structurées en un segment en forme de bande ;
lors d'une deuxième étape, des écarteurs intérieurs (5) sont réalisés à partir d'un diélectrique latéralement par rapport au segment en forme de bande de ces couches structurées (3, 4) qui est prévu pour constituer une base ;
lors d'une troisième étape, des écarteurs extérieurs (6) sont réalisés latéralement par rapport à ces écarteurs (5) à partir d'un diélectrique qui, par rapport au diélectrique des écarteurs intérieurs (5), peut être attaqué sélectivement ;
lors d'une quatrième étape, la couche de silicium (20) qui se trouve sur la couche isolante (1) est, en utilisant comme masque les écarteurs intérieurs (5), les écarteurs extérieurs (6) et la couche de diélectrique structurée (4), entièrement enlevée en dehors de la zone recouverte par ce masque de sorte qu'il subsiste une couche de silicium (2) ;
lors d'une cinquième étape, une autre couche de diélectrique (70) est appliquée de manière uniforme sur toute la surface ;
lors d'une sixième étape, cette autre couche de diélectrique (70) est réattaquée pour aplanir, à l'exception des segments (7) restants sur les côtés des écarteurs extérieurs (6) ;
lors d'une septième étape, les écarteurs extérieurs (6) sont enlevés sélectivement ;
lors d'une huitième étape, le segment restant de la couche de silicium (2) est, en utilisant comme masque les couches diélectriques appliquées (4, 5), enlevé jusqu'à la couche isolante (1) dans la zone des écarteurs extérieurs (6) de manière à créer des ouvertures (8) des deux côtés ;
lors d'une neuvième étape, une couche (9) fortement dopée prévue pour l'émetteur et le collecteur est appliquée sur toute la surface ;
lors d'une dixième étape, cette couche (9) est réattaquée pour aplanir et est structurée de manière à créer une couche d'émetteur (91) et une couche de collecteur (92) séparées l'une de l'autre ;
lors d'une onzième étape, une couche (10) pour aplanir est appliquée à partir d'un diélectrique, couche dans laquelle sont ensuite formés des trous de contact destinés à la jonction électrique, puis dans laquelle sont appliqués un contact d'émetteur (11), un contact de collecteur (12) et un contact de base (13).

2. Procédé selon la revendication 1, dans lequel
du SiO₂ est utilisé lors de la première étape pour la couche de diélectrique (4), lors de la deuxième étape pour les écarteurs intérieurs (5) et lors de la cinquième étape pour l'autre couche de diélectrique (70) ;
du Si₃N₄ est utilisé lors de la troisième étape pour les écarteurs extérieurs (6).

3. Procédé selon la revendication 1 ou 2, dans lequel,
lors de la première étape, la couche de polysilicium (3) est réalisée de manière à être du type p⁺ ;
lors de la neuvième étape, la couche (9) est réalisée à partir d'un matériau contenant du silicium de manière à être du type n⁺.
